## Europäisches Patentamt

## European Patent Office

## Office européen des brevets

(19)

(11) Numéro de publication : **0 080 394**
**B1**

(12)

# FASCICULE DE BREVET EUROPÉEN

(45) Date de publication du fascicule du brevet :
24.04.85

(21) Numéro de dépôt : 82402024.2

(22) Date de dépôt : 03.11.82

(51) Int. Cl.⁴ : **H 03 K   3/356**

(54) **Bascule bistable à stockage non volatil et à repositionnement statique.**

(30) Priorité : 20.11.81 FR 8121801

(43) Date de publication de la demande :
01.06.83 Bulletin 83/22

(45) Mention de la délivrance du brevet :
24.04.85 Bulletin 85/17

(84) Etats contractants désignés :
CH DE FR GB IT LI NL

(56) Documents cités :
DE-A- 2 622 307
US-A- 4 128 773
US-A- 4 207 615
PROCEEDINGS OF THE IEEE, vol. 58, no. 8, août
1970, pages 1207-1219, New York (USA); D.
FROHMAN-BENTCHKOWSKY: "The metal-nitride-
oxide-silicon (MNOS) transistor characteristics and
applications"

(73) Titulaire : SOCIETE POUR L'ETUDE ET LA FABRICA-
TION DE CIRCUITS INTEGRES SPECIAUX - E.F.C.I.S.
17, avenue des Martyrs
F-38100 Grenoble (FR)

(72) Inventeur : Brice, Jean-Michel
THOMSON-CSF SCPI 173, bld Haussmann
F-75379 Paris Cedex 08 (FR)
Inventeur : Maillart, Patrick
THOMSON-CSF SCPI 173, bld Haussmann
F-75379 Paris Cedex 08 (FR)

(74) Mandataire : de Beaumont, Michel et al
THOMSON-CSF SCPI 173, Bld Haussmann
F-75379 Paris Cedex 08 (FR)

Jouve, 18, rue St-Denis, 75001 Paris, France

## Description

La présente invention concerne le domaine des circuits de sauvegarde et plus particulièrement une bascule bistable dont le contenu, à un instant donné, peut être stocké de façon non volatile dans des éléments de stockage, la bascule pouvant être ensuite repositionnée selon les informations stockées.

La présente invention permet la mémorisation des informations contenues dans une bascule bistable pour le cas où l'alimentation de cette bascule viendrait à s'interrompre, puis le repositionnement de cette bascule une fois que la tension d'alimentation est rétablie.

On s'intéressera ici essentiellement aux structures de types MOS, c'est-à-dire à des structures à effet de champ à grille conductrice (par exemple un métal M) formée sur une couche isolante (par exemple un oxyde O) au-dessus d'un semiconducteur (S).

On connaît déjà de telles bascules avec sauvegarde de l'état, d'après les brevets US-A 4 128 773 et DE-A 2 622 307.

La présente invention propose une bascule bistable améliorée, ayant un circuit de sauvegarde, visant à satisfaire notamment aux caractéristiques suivantes :

— sûreté de fonctionnement et, notamment :

inscription dans des éléments de stockage non volatile à partir de l'état de la bascule bistable toujours possible dans tous les cas de fonctionnement,

repositionnement correct du bistable lors de sa remise sous tension à partir de l'état des éléments de stockage non volatile et seulement sur un ordre précis,

non perturbation du bistable par les éléments de stockage en dehors de la phase de repositionnement,

— facilité d'utilisation :

réduction du nombre de commandes particulières nécessaires pour la fonction de sauvegarde,

rapidité des séquences de prise en mémoire et de repositionnement, en particulier en ce qui concerne la mémorisation qui doit être la plus courte possible.

Pour satisfaire ces diverses exigences, la présente invention prévoit une bascule à laquelle est adjoint un circuit de sauvegarde lui permettant d'avoir une fonction de stockage non volatil, la commande des opérations de mise en mémoire, de stockage et de repositionnement pouvant être effectuée à l'aide d'une seule ligne de commande.

Pour atteindre ces objets, la présente invention prévoit, selon la revendication 1, une bascule à stockage non volatil constituée d'une bascule bistable classique à transistors MOS comportant des nœuds Q et Q* et connectée entre un potentiel d'alimentation et un potentiel de référence, comprenant en outre deux branches de stockage dont chacune est constituée par le montage en série d'un élément de stockage non volatil du type transistor MOS à tension de seuil programmable électriquement et d'un élément interrupteur du type transistor MOS, une borne de chacun des éléments interrupteurs étant reliée au potentiel d'alimentation, l'une des bornes principales et la borne de commande de l'élément de stockage de la première branche étant connectées respectivement au nœud Q et au nœud Q* et inversement pour l'élément de stockage de la deuxième branche ; caractérisée en ce que les deux bornes de commande des éléments interrupteurs sont connectées ensemble à une source de signal de commande ; et en ce qu'il est prévu des moyens pour modifier le potentiel d'alimentation en relation avec le signal de commande de la manière suivante :

— en fonctionnement normal de la bascule, le potentiel d'alimentation a une valeur normale et le signal de commande maintient les deux transistors interrupteurs bloqués ;

— pendant une phase de mise en mémoire, le potentiel d'alimentation est porté à une valeur plus élevée et le signal de commande maintient les deux transistors interrupteurs bloqués ;

— pendant une phase de stockage rémanent, le potentiel d'alimentation et le signal de commande sont indifférents ;

— pendant une phase de repositionnement, le signal de commande met en conduction les deux transistors interrupteurs, après quoi le potentiel d'alimentation est amené de zéro à sa valeur normale.

Des modes de réalisation de l'invention selon la revendication 1 sont revendiquées par les revendications 2 et 3. Deux modifications de l'invention selon la revendication 1 sont revendiquées par les revendications indépendantes 4 et 5.

La bascule bistable classique peut par exemple être du type à transistors MOS complémentaires ou à transistors MOS enrichis et déplétés. Les éléments de stockage peuvent être des transistors MNOS (métal-nitrure-oxyde-semiconducteur) dont le substrat est relié à la source. Ces éléments de stockage peuvent aussi être du type à grille flottante. Comme transistor interrupteur, on pourra choisir des transistors MOS à grille isolée à canal P, les éléments de stockage étant du type à canal N. Pour permettre le fonctionnement de la bascule non volatile selon l'invention dans ses quatre phases, à savoir fonctionnement normal indépendamment de tout stockage, mémorisation, stockage et repositionnement, le potentiel d'alimentation peut varier entre un premier niveau propre à assurer le fonctionnement de la bascule classique et un deuxième niveau propre à conditionner l'élément de stockage. Ce potentiel d'alimentation est également susceptible d'être interrompu, c'est pourquoi l'on prévoit un stockage non volatil. Le signal de commande appliqué aux éléments interrupteurs peut varier entre une première valeur permettant le blocage des éléments interrupteurs et une deuxième valeur assurant la conduction de ces éléments.

Pendant les phases de fonctionnement normal de la bascule, le potentiel d'alimentation est au premier niveau et le signal de commande à la première valeur. Pendant les phases de mémorisation, le potentiel d'alimentation est au deuxième niveau, le signal de commande restant à la première valeur ou s'alignant sur le deuxième niveau. Pendant les phases de stockage, le potentiel d'alimentation et le signal de commande sont nuls ou flottants. Enfin, pendant les périodes de repositionnement, le signal d'alimentation est rétabli à son premier niveau tandis que le signal de commande est d'abord à la deuxième valeur avant de remonter à la première valeur pour revenir à l'état de fonctionnement normal de la bascule.

Selon un avantage de la présente invention, on notera que les éléments de stockage sont amenés à subir un cycle de fonctionnement seulement aux instants où l'on souhaite mémoriser le contenu de la bascule. Il n'y a pas de changement d'état de ces éléments à chaque changement d'état de la bascule. Cette caractéristique est importante, notamment quand on utilise des éléments de stockage du type transistor MNOS étant donné que le nombre de cycles de fonctionnement de tels transistors MNOS est limité à des valeurs de l'ordre de $10^6$ à $10^8$ cycles.

La présente invention présente également les avantages exposés précédemment dans l'énoncé de ses objets auxquels il convient d'ajouter que la prise en mémoire se fait de façon particulièrement simple et rapide, en un seul cycle de commande.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1  représente sous forme schématique et généralisée une bascule selon la présente invention,

la figure 2  représente un mode de réalisation particulier d'un dispositif selon l'invention dans lequel la bascule classique est à transistors MOS complémentaires,

la figure 3  représente les tensions appliquées au dispositif lors de ses diverses phases de fonctionnement,

la figure 4  représente l'évolution des tensions appliquées au dispositif lors du repositionnement de la bascule après une phase de stockage,

les figures 5 à 7  représentent diverses variantes du mode de réalisation de la figure 2,

la figure 8  représente un mode de réalisation particulier d'un dispositif selon l'invention dans lequel la bascule classique est à transistors MOS enrichis/déplétés.

Dans les diverses figures représentant des bascules bistables, les conducteurs et les périphériques d'accès aux bascules vers les nœuds Q et Q* n'ont pas été figurés. Ils seront réalisés de façon classique.

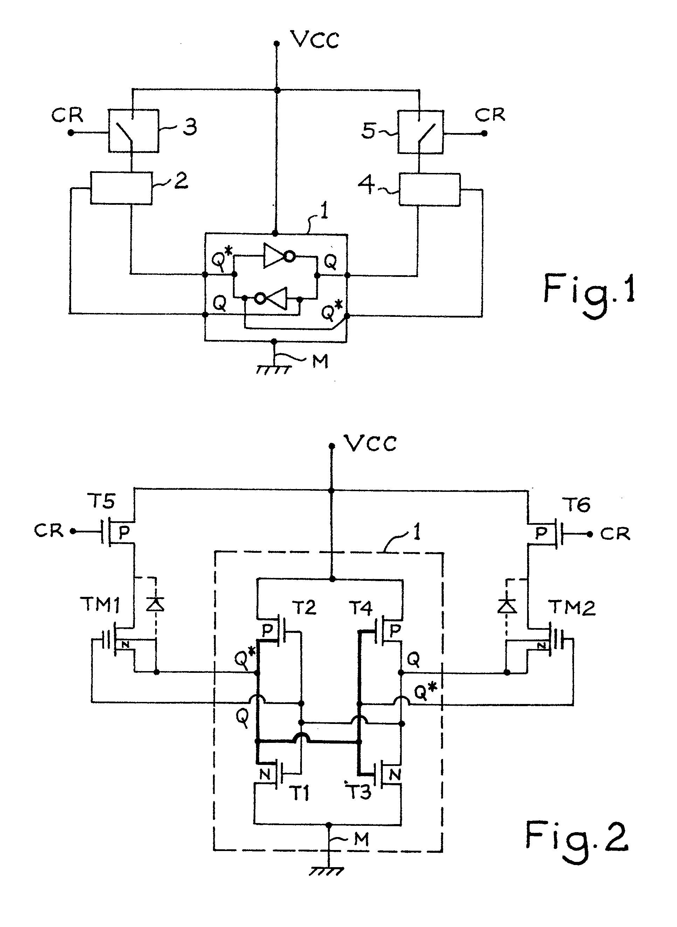

La figure 1 représente de façon générale et schématique le circuit selon la présente invention. Ce circuit comprend une bascule bistable classique présentant des bornes ou nœuds complémentaires Q et Q* qui peuvent chacune prendre l'un ou l'autre des deux états logiques, mais jamais le même état. Cette bascule est connectée entre une source d'alimentation VCC, couramment 5 volts, et une tension de référence M, couramment la masse. Ainsi, en fait, les deux états logiques Q et Q* correspondent à la tension VCC ou au potentiel de la masse. Pour le fonctionnement normal d'une bascule, le potentiel VCC est couramment de l'ordre de 5 volts.

On suppose ici que la bascule 1 est de type volatil ou non rémanent, c'est-à-dire qu'en cas d'interruption du potentiel VCC, le dernier état qu'a atteint la bascule est perdu. Pour remédier à cet état de choses et créer une sauvegarde de la dernière information mémorisée avant la coupure du courant, il est prévu d'adjoindre à la bascule deux branches de stockage comprenant chacune un élément de stockage, respectivement 2 et 4, et un interrupteur commandé, respectivement 3 et 5. Ces deux branches sont disposées entre l'une des sorties de la bascule et la tension d'alimentation VCC. Les interrupteurs commandés 3 et 5 reçoivent une même tension de commande CR, c'est-à-dire qu'ils sont simultanément ouverts ou fermés. Les éléments de stockage 2 et 4 sont des transistors MOS à deux tensions de seuil programmables électriquement comprenant deux bornes principales et une borne de commande. La borne de commande est reliée au nœud de la bascule complémentaire de celui auquel est connectée l'une des bornes principales.

Pour effectuer une opération de sauvegarde, c'est-à-dire de conditionnement des éléments de stockage 2 et 4, on procède à une élévation de la tension d'alimentation VCC juste avant une coupure de cette alimentation. En cas de coupure volontaire de la tension d'alimentation, ceci est facile à réaliser. En cas de coupure accidentelle de la tension d'alimentation, on connaît des circuits pour fournir pendant une courte durée une telle tension haute dès que l'on détecte une baisse de la tension normale d'alimentation, la source de tension haute pouvant par exemple consister en des capacités tampons normalement alimentées pendant le fonctionnement normal du dispositif. Ainsi, à l'instant de l'application de la tension haute, un potentiel élevé se trouve appliqué entre les nœuds Q et Q* de la bascule et agit de façon inverse entre la borne de commande et l'une des bornes principales pour chacun des éléments de stockage 2 et 4. Ceci, à condition que la tension de seuil de programmation des éléments de stockage soit supérieure à la tension de fonctionnement normal de la bascule, ce qui est généralement le cas dans les dispositifs classiques, permet de conditionner les éléments de stockage 2 et 4 dans des états complémentaires. La façon dont l'état mémorisé dans les éléments de stockage 2 et 4 est utilisé pour repositionner la bascule lors de la réalimentation du dispositif sera exposée en détail ci-après en relation avec la description d'un mode de réalisation particulier de la présente invention en vue de simplifier la description.

Des éléments de stockage répondant à la définition générale de « transistors MOS à tension de seuil programmable électriquement » sont par exemple des cellules MNOS (métal nitrure oxyde semiconducteur) ou des transistors à grille flottante comme, par exemple, ceux désignés couramment dans la technique sous l'appellation transistors Flotox. Dans la pratique, on choisira comme éléments de stockage 2 et 4 des éléments réalisables dans une technologie compatible avec celle selon laquelle est réalisée la bascule bistable 1. Par exemple, si l'on utilise des transistors à grille flottante de type Flotox, il semble à l'heure actuelle que la technologie de bascule la plus simplement compatible soit à la technologie MOS à canal N enrichi/déplété. Avec une technologie de type MNOS pour les éléments de stockage, la réalisation d'une bascule MOS de type à transistors complémentaires (CMOS) semble aujourd'hui l'une des plus compatibles. C'est ce mode de réalisation particulier qui va être décrit ci-après à titre d'exemple, et qui va être utilisé pour fournir une description détaillée du procédé de fonctionnement de la bascule bistable à stockage non volatil et à repositionnement statique selon l'invention.

Dans le mode de réalisation particulier représenté en figure 2, la bascule 1 est à transistors MOS complémentaires. Elle comprend quatre transistors T1 à T4, les transistors T1 et T3 étant des transistors à canal N et les transistors T2 et T4 des transistors à canal P. Les transistors T1 et T2 sont placés en série entre la masse et le potentiel d'alimentation VCC, de même que les transistors T3 et T4. Les grilles des transistors T1 et T2 sont connectées au point de jonction source/drain des transistors T3 et T4 et les grilles des transistors T3 et T4 sont connectées au point de jonction source/drain des transistors T2 et T1. On appelle Q* la borne correspondant à la connexion des grilles des transistors T3 et T4 et Q la borne correspondant à la connexion des grilles des transistors T1 et T2.

Le fonctionnement de cette bascule, bien connue en elle-même, ne sera pas décrit en détail ici. A cette bascule sont adjointes selon l'invention deux branches de stockage. La première branche connectée au nœud Q* comprend un élément MNOS TM1 en série avec un transistor MOS à canal P T5 dont l'autre borne est reliée à la tension d'alimentation VCC. De même, la deuxième branche connectée entre le nœud Q et le potentiel d'alimentation VCC comprend un élément MNOS TM2 et un transistor à canal P T6. Les grilles des transistors à canal P T5 et T6 sont interconnectées et reliées à une source de signal de commande CR. La grille de l'élément de stockage MNOS TM1 est connectée au nœud Q et celle de l'élément TM2 au nœud Q*. La source et le substrat des transistors TM1 et TM2 sont interconnectées et reliées comme celle a déjà été

exposé aux nœuds Q* et Q. On a figuré en pointillés, bien que cela ne soit pas essentiel à l'exposé de la présente invention, entre les bornes de substrat et de drain des transistors TM1 et TM2, des diodes de fuite parasites inhérentes à la réalisation de ces éléments.

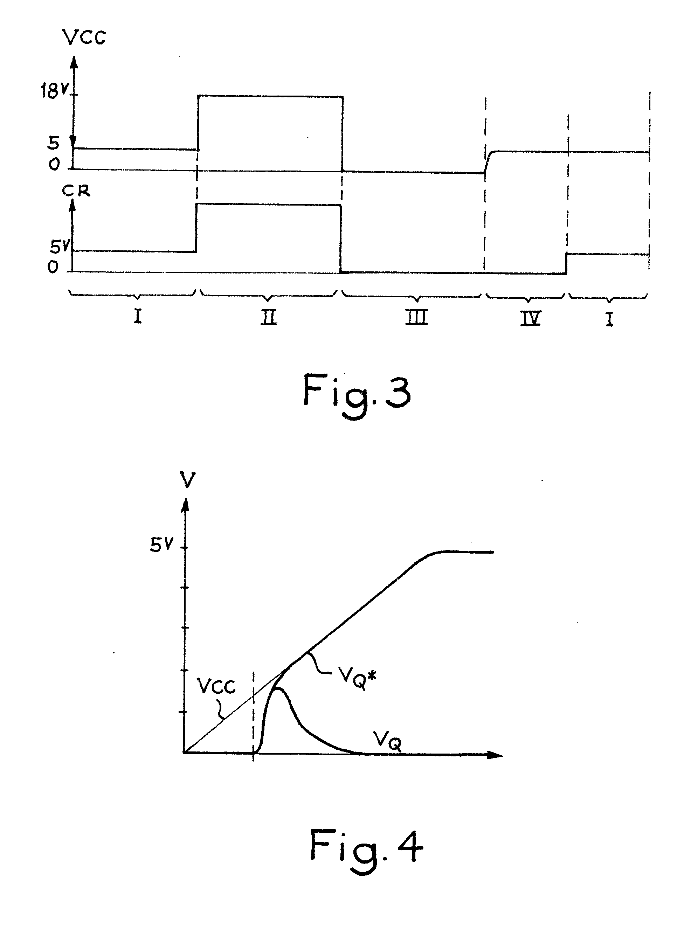

On va maintenant décrire le fonctionnement du dispositif en relation avec la figure 3 qui représente la tension appliquée à la borne d'alimentation VCC et à la borne de commande CR.

Dans une phase I de fonctionnement normal, la tension VCC est la tension normale de fonctionnement de la bascule, par exemple 5 volts. Le signal de commande CR est également à niveau haut, par exemple 5 volts comme VCC, pour que les transistors T5 et T6 soient non conducteurs ou bloqués. Dans cette configuration, la tension appliquée entre grille et source-substrat des éléments TM1 et TM2 est de plus ou moins 5 volts, c'est-à-dire insuffisante pour changer l'état de seuil de ces éléments. Ainsi, du fait de la coupure des transistors T5 et T6, l'influence des branches de stockage sur le fonctionnement de la bascule est pratiquement négligeable. Leur seule influence réside dans la charge capacitive supplémentaire imposée aux nœuds Q et Q* par la présence des éléments MNOS. Selon une caractéristique importante de l'invention, on notera que la différence de potentiel de l'ordre de 5 volts infligée aux éléments MNOS pendant les changements d'état de la bascule qui, comme on l'a vu, n'entraîne pas une programmation de ces éléments, ne produit pas de phénomènes de vieillissement pour ces éléments. La bascule bistable peut donc basculer un nombre illimité de fois dans ces conditions.

Dans l'étape II de prise en mémoire, le potentiel à la borne VCC est porté momentanément à un niveau élevé par rapport au potentiel de référence, propre à agir sur les tensions de seuil des éléments MNOS, ce potentiel étant par exemple de 18 volts. Simultanément, le signal CR passe à 18 volts en suivant la tension VCC. Dans cet état, les éléments MNOS TM1 et TM2 voient entre leur grille et leur source-substrat, une tension de plus ou moins 18 volts. Plus spécifiquement, en supposant que Q* est à haut niveau et Q à bas niveau dans le dernier état de la bascule, l'élément TM1 voit 0 volt sur sa grille et 18 volts sur sa source et son substrat alors que l'élément TM2 reçoit une tension de 18 volts sur sa grille et une tension de 0 volt sur sa source et son substrat. En conséquence, l'élément TM1 se trouve programmé à sa tension de seuil basse et l'élément TM2 acquiert une tension de seuil haute. Ainsi, pour une tension grille-source nulle, l'élément TM1 se trouve dans un état déplété, c'est-à-dire qu'il est conducteur (faible impédance) entre son drain et sa source alors que l'élément TM2 se trouve dans un état enrichi, c'est-à-dire qu'il est bloqué (haute impédance) entre son drain et sa source. Cette phase de mémorisation se déroule sans circulation de courant statique du fait que les transistors T5 et T6 sont bloqués, c'est-à-dire que la consommation du circuit reste très faible.

Après cette phase de mise en mémoire, on peut repasser directement en fonctionnement normal, l'état stocké dans les éléments MNOS permettant éventuellement de repositionner ultérieurement la bascule à son état existant à l'instant de la mémorisation. Mais couramment, la phase de mise en mémoire est suivie d'une phase III de stockage pendant laquelle la tension d'alimentation VCC ainsi que la tension appliquée comme signal de commande CR sont nulles ou flottantes.

Pour repositionner ensuite la bascule, comme cela est représenté dans la phase IV de la figure 3, un potentiel d'alimentation VCC est réappliqué alors que le signal CR est maintenu à zéro. En se plaçant dans le cas exposé précédemment, l'élément TM1 est conditionné dans l'état conducteur et l'élément TM2 dans l'état bloqué. Tandis que la tension VCC s'élève, les transistors à canal P T2, T4, T5, T6 restent bloqués tant que leur tension de seuil $V_{TP}$ n'est pas atteinte. Lorsque la tension VCC dépasse cette valeur, les transistors à canal P commencent à conduire, ce qui a pour effet d'élever le potentiel des nœuds Q et Q*. Alors, du fait de la conduction de la première branche de stockage (T5, TM1), le potentiel du nœud Q* tend à suivre l'élévation de potentiel VCC et à imposer un potentiel opposé sous l'effet du fonctionnement de la bascule sur la grille des transistors T1 et T2, c'est-à-dire que le transistor T2 se bloque et que le transistor T1 tend à conduire. On a alors un potentiel bas au niveau du nœud Q et un potentiel élevé au niveau du nœud Q*. L'évolution des tensions ($V_Q$ et $V_{Q*}$) avec la variation du potentiel VCC est représentée plus en détail en figure 4.

Le fonctionnement lors de la phase de repositionnement suppose que le signal CR se maintient bien à 0 volt. Ceci pose en fait le problème du comportement des périphériques dans la phase de remise sous tension. En effet, il est difficile d'assurer qu'un potentiel reste bien nul tant que la tension d'alimentation n'atteint pas au moins la tension de seuil des transistors à canal N, donc tant qu'aucun transistor ne conduit. Les nœuds de sortie Q et Q* sont alors en état de haute impédance et ce sont les couplages capacitifs qui déterminent les potentiels. C'est pourquoi, bien que le dispositif décrit fasse appel à un repositionnement statique, l'aspect dynamique ne doit pas être négligé dans les cas limites où le décalage introduit par les éléments MNOS est faible. En particulier, les nœuds Q et Q* peuvent suivre VCC par l'intermédiaire des diodes parasites, des capacités des transistors et des capacités parasites. La valeur du temps de montée de la tension VCC doit donc être prise en considération. Plus ce temps de montée est long, plus l'aspect capacitif peut être négligé.

D'un point de vue technologique, le schéma indiqué pour le dispositif en figure 2 peut être réalisé en technologie CMOS sur substrat massif ou sur substrat isolant. Dans le cas d'un substrat isolant, les transistors sont naturellement isolés les uns des autres. Par contre, sur un substrat massif, les transistors à canal N T1 et T3 ainsi que les éléments MNOS à canal N TM1 et TM2 sont implantés dans des caissons de type P. Ces caissons sont reliés soit à la masse du circuit, soit à la source des transistors à canal N qu'ils contiennent comme cela est représenté dans la figure. La diode parasite caisson/substrat n'intervient que par sa capacité de jonction car sa tenue en tension est très supérieure aux tensions appliquées et son courant de fuite négligeable.

On va maintenant décrire diverses variantes du mode de réalisation exposé précédemment, ces variantes permettant d'améliorer certaines caractéristiques de la bascule et notamment la sûreté de fonctionnement durant la phase de repositionnement.

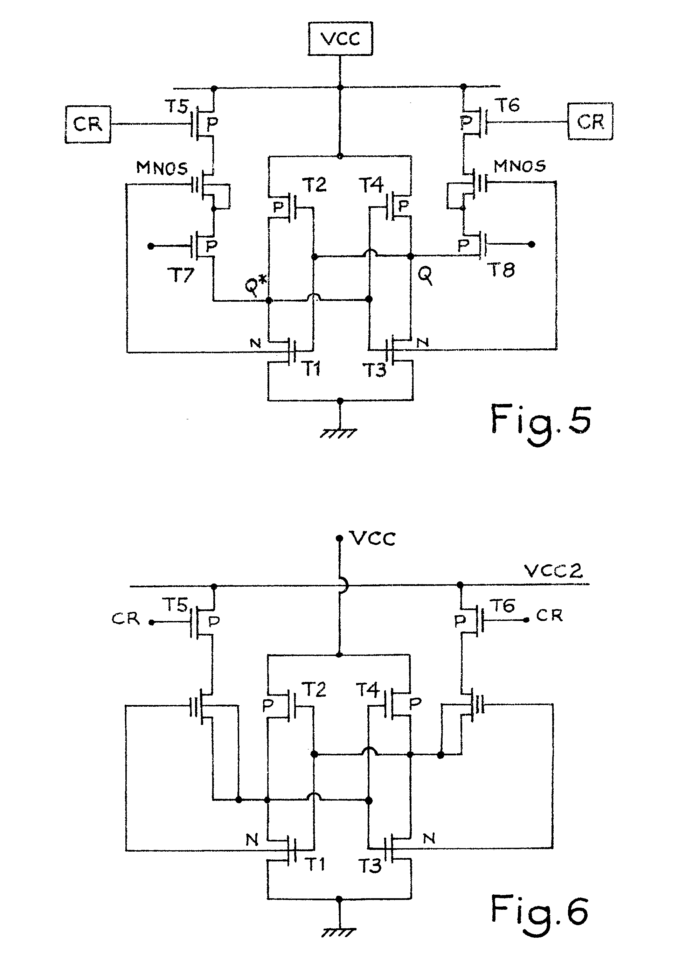

Dans la variante illustrée en figure 5, le montage est identique à celui de la figure 2, sauf que deux transistors à canal P T7 et T8 sont ajoutés, respectivement insérés entre la source des transistors MNOS TM1 et TM2 et les nœuds Q* et Q. Le mode d'action dans les différentes phases sur la tension d'alimentation VCC et sur la source de signal CR est identique à celui de la figure 2. Les transistors T7 et T8 sont bloqués pendant les phases de fonctionnement normal de la bascule et permettent ainsi de réduire la charge capacitive imposée aux nœuds Q et Q* en isolant ces nœuds par rapport aux éléments MNOS. Le signal de commande sur les grilles des transistors T7 et T8 est identique au signal de commande CR pendant toutes les phases sauf la phase II de mise en mémoire pendant laquelle ces transistors doivent être conducteurs. Ainsi, on paye l'amélioration des caractéristiques dynamiques de la bascule par la nécessité de prévoir deux transistors supplémentaires et une ligne de commande spécifique.

Une deuxième variante est illustrée en figure 6. Le montage est identique à celui de la figure 2, sauf que l'on a séparé l'alimentation VCC de la bascule bistable de l'alimentation des branches de stockage (VCC2). Le but de cette variante est d'améliorer la sûreté de fonctionnement, c'est-à-dire principalement la phase de repositionnement en éliminant l'action des charges (T2 et T4) de la bascule bistable pendant ce repositionnement. Ce sont alors les branches de stockage qui constituent les charges. Dans la phase IV de repositionnement, la tension VCC est d'abord laissée flottante, tandis que la tension VCC2 croît. De ce fait, aucun courant ne peut circuler dans les charges pendant le repositionnement de la bascule. Ce n'est que lorsque celle-ci est positionnée (VCC2 atteint 5 volts par exemple) que la tension VCC est portée à sa valeur nominale (également 5 volts par exemple) mettant ainsi en service des charges de la bascule bistable. Une fois le positionnement terminé, étant donné que le signal de commande CR bloque les transistors à canal P T5 et T6, la valeur de la tension VCC2 est indifférente, pourvu qu'elle soit inférieure ou égale à VCC.

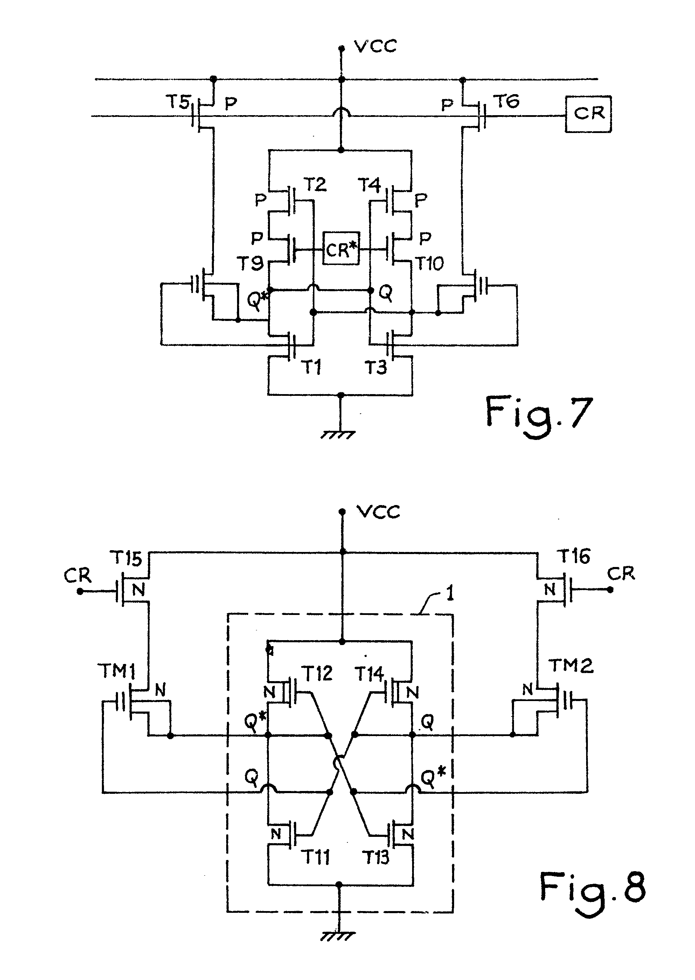

Une troisième variante illustrée en figure 7, a le même but que la deuxième variante, à savoir d'isoler les charges. Le schéma est identique à celui de la figure 2, sauf que deux transistors T9 et T10 sont insérés respectivement entre les transistors T1 et T2, d'une part, et T3 et T4, d'autre part. Ces transistors sont commandés par un signal de commande CR* complémentaire du signal CR. Ainsi, ces transistors sont toujours conducteurs sauf pendant la phase de repositionnement où ils isolent les charges des nœuds Q et Q*. Ainsi, pendant la première partie de la montée de la tension VCC au cours du repositionnement, le signal CR est maintenu à 0 pour rendre conducteurs les transistors T5 et T6 tandis que CR* suit VCC pour bloquer les transistors T9 et T10 dès que la tension VCC dépasse la tension de seuil des transistors à canal P. Les charges constituées par les transistors T2 et T4 sont donc isolées par rapport aux nœuds Q et Q* et ce sont les éléments MNOS qui contrôlent leur potentiel selon leur tension de seuil (leur état de conductivité).

La figure 8 représente un autre mode de réalisation de la présente invention dans lequel la bascule classique 1 est réalisée non plus au moyen de transistors MOS complémentaires, mais au moyen d'une association de transistors MOS enrichis/déplétés. Cette bascule comprend quatre transistors à canal N T11 à T14. Les transistors T11 et T12 sont en série ainsi que les transistors T13 et T14. Les transistors T11 et T13 sont du type à enrichissement, c'est-à-dire normalement non conducteurs, et les transistors T12 et T14 sont du type à déplétion, c'est-à-dire normalement conducteurs. Les grilles des transistors T12 et T13 sont connectées entre elles et à la connexion drain/source des transistors T11 et T12. Les grilles des transistors T11 et T14 sont connectées entre elles et à la connexion drain/source des transistors T13 et T14.

Les branches de stockage et les éléments de stockage sont connectés de la même façon que cela a été décrit précédemment en relation avec la figure 2. La bascule bistable 1 illustrée en figure 8 est connue en elle-même. Elle a été décrite ici seulement pour souligner que la présente invention n'est pas limitée à une utilisation avec un type de bascule particulier. Pour plus de sûreté de fonctionnement, il est recommandé d'utiliser plutôt la variante de la figure 6 avec ce type de technologie car les charges normales de la cellule (T12, T14) conduisent tout de suite à la montée de la tension VCC et perturbent la remise sous tension. Il est donc recommandé d'isoler ces charges déplétées pendant le repositionnement. On notera que, dans le cas où l'on choisit une technologie de bascule classique à transistors à canal N enrichis/déplétés, les ressources technologiques habituelles permettent d'associer simplement une telle bascule avec des transistors à grille flottante comme éléments de stockage TM1 et TM2.

Jusqu'à présent, on a décrit une bascule bistable associée à deux branches de stockage lui permettant d'avoir une fonction de bascule non volatile. La bascule classique décrite précédemment était du type symétrique et devait d'ailleurs avoir un fonctionnement aussi symétrique que possible pour pouvoir fonctionner de façon satisfaisante même quand la distance entre les deux seuils des éléments de stockage TM1 et TM2 se réduit tandis que ces dispositifs vieillissent. Il serait également possible de prévoir une bascule bistable a priori dissymétrisée, c'est-à-dire se repositionnant automatiquement sur un certain état en l'absence de branches de stockage, et d'associer à une telle bascule dissymétrique une branche de stockage unique permettant de la repositionner dans son autre état quand l'élément de stockage associé à cette bascule se trouve dans son état de faible impédance. Le mode de commande d'une telle bascule dissymétrique est identique à ce qui a été décrit précédemment. L'avantage de cette structure réside dans la réduction de la surface de silicium utilisée, mais l'inconvénient est que la bascule bistable dissymétrique est moins sensible qu'une bascule symétrique, ce qui signifie notamment qu'elle exige pour son fonctionnement une plus grande différence entre l'état bloqué et l'état de conduction de l'élément MNOS, c'est-à-dire une plus grande fenêtre mémoire.

Les diverses variantes exposées précédemment ne sont que des exemples de modifications qui peuvent être apportées au schéma de base illustré de façon particulière en figure 2 et de façon plus générale en figure 1. Bien entendu, d'autres variantes peuvent être prévues sans sortir du domaine de la présente invention et, notamment, les diverses variantes illustrées peuvent être combinées.

## Revendications

1. Bascule bistable à stockage non volatil (figure 2, 5, 7 ou 8) constituée d'une bascule bistable classique à transistors MOS (T1 à T4 ou T11 à T14) comportant des nœuds Q et Q* et connectée entre un potentiel d'alimentation (VCC) et un potentiel de référence (M), comprenant en outre deux branches de stockage dont chacune est constituée par le montage en série d'un élément de stockage non volatil (TM1, TM2) du type transistor MOS à tension de seuil programmable électriquement et d'un élément interrupteur (T5, T6 ou T15, T16) du type transistor MOS, une borne de chacun des éléments interrupteurs étant reliée au potentiel d'alimentation, l'une des bornes principales et la borne de commande de l'élément de stockage de la première branche étant connectées respectivement au nœud Q et au nœud Q* et inversement pour l'élément de stockage de la deuxième branche ; caractérisée en ce que les deux bornes de commande des éléments interrupteurs sont connectées ensemble à une source de signal de commande (CR) ; et en ce qu'il est prévu des moyens pour modifier le potentiel d'alimentation (VCC) en relation avec le signal de commande (CR) de la manière suivante :

— en fonctionnement normal de la bascule, le potentiel d'alimentation (VCC) a une valeur normale et le signal de commande (CR) maintient les deux transistors interrupteurs bloqués ;

— pendant une phase de mise en mémoire, le potentiel d'alimentation est porté à une valeur plus élevée et le signal de commande maintient les deux transistors interrupteurs bloqués ;

— pendant une phase de stockage rémanent, le potentiel d'alimentation et le signal de commande sont indifférents ;

— pendant une phase de repositionnement, le signal de commande met en conduction les deux transistors interrupteurs, après quoi le potentiel d'alimentation est amené de zéro à sa valeur normale.

2. Bascule bistable à stockage non volatil selon la revendication 1, caractérisée en ce qu'elle comprend en outre des transistors MOS à canal P (T7, T8, Figure 5) insérés respectivement entre chacun des éléments de stockage (TM1, TM2) et les nœuds Q et Q*, le potentiel appliqué aux grilles de ces transistors MOS étant identique à la valeur du signal CR sauf pendant la phase de mise en mémoire.

3. Bascule selon la revendication 1, dans laquelle les transistors interrupteurs sont à canal P et les éléments de stockage sont à canal N, caractérisé en ce qu'il est prévu des transistors supplémentaires à canal P (T9, T10, Figure 7) dans chacune des branches de la bascule bistable entre les transistors complémentaires constituant ces branches, ces transistors supplémentaires à canal P étant commandés par un signal de commande CR* complémentaire du signal de commande appliqué aux éléments interrupteurs (T5, T6).

4. Bascule bistable à stockage non volatil (Figure 6) constituée d'une bascule bistable classique à transistors MOS (T1 à T4) comportant des nœuds Q et Q* et connectée entre une ligne d'alimentation (VCC) et un potentiel de référence (M), comprenant en outre deux branches de stockage dont chacune est constituée par le montage en série d'un élément de stockage non volatil (TM1, TM2) du type transistor MOS à tension de seuil programmable électriquement et d'un élément interrupteur (T5, T6) du type transistor MOS, une borne de chacun des éléments interrupteurs étant reliée à une autre ligne d'alimentation (VCC2), l'une des bornes principales et la borne de commande de l'élément de stockage de la première branche étant connectées respectivement au nœud Q et au nœud Q* et inversement pour l'élément de stockage de la deuxième branche ; caractérisée en ce que les deux bornes de commande des éléments interrupteurs sont connectées ensemble à une source de signal de commande (CR) ; et en ce qu'il est prévu des moyens pour modifier le potentiel d'alimentation (VCC) en relation avec le signal de commande (CR) de la manière suivante :

— en fonctionnement normal de la bascule, les lignes d'alimentation sont portées à des valeurs de potentiel normales et le signal de commande maintient les deux transistors interrupteurs bloqués ;

— pendant une phase de mise en mémoire, les lignes d'alimentation sont portées à des potentiels plus élevés et le signal de commande maintient les deux transistors interrupteurs bloqués ;

— pendant une phase de stockage rémanent, les lignes d'alimentation et le signal de commande sont portés à des valeurs indifférentes ;

— pendant une phase de repositionnement, le signal de commande met en conduction les transistors interrupteurs, après quoi, la première ligne d'alimentation (VCC) est d'abord laissée flottante pendant qu'on fait passer la seconde de zéro à sa valeur normale, puis la première ligne est amenée à son potentiel normal.

5. Bascule bistable à stockage non volatil constituée d'une bascule bistable classique à transistors MOS comportant des nœuds Q et Q* et connectée entre un potentiel d'alimentation et un potentiel de référence, comprenant en outre une branche de stockage constituée par le montage en série d'un élément de stockage non volatil du type transistor MOS à tension de seuil programmable électriquement et d'un élément interrupteur du type transistor MOS, une borne de l'élément interrupteur étant reliée au potentiel d'alimentation, l'une des bornes principales et la borne de commande de l'élément de stockage étant connectée respectivement au nœud Q et au nœud Q*, caractérisée en ce que la borne de commande de l'élément interrupteur est connectée à une source de signal de commande, et en ce qu'il est prévu des moyens pour modifier le potentiel d'alimentation en relation avec le signal de commande de la manière suivante :

— en fonctionnement normal de la bascule, le potentiel d'alimentation a une valeur normale et le signal de commande maintient le transistor interrupteur bloqué ;

— pendant une phase de mise en mémoire, le potentiel d'alimentation est porté à une valeur plus élevée et le signal de commande maintient le transistor interrupteur bloqué ;

— pendant une phase de stockage rémanent, le potentiel d'alimentation est le signal de commande sont indifférents ;

— pendant une phase de repositionnement, le signal de commande met en conduction le transistor interrupteur, après quoi le potentiel d'alimentation est amené de zéro à sa valeur normale.

**Claims**

1. Non-volatile bistable latch (figure 2, 5, 7 or 8) formed of a conventional bistable latch having MOS transistors (T1 to T4 or T11 to T14) and comprising nodes Q and Q* and connected between a supply potential (VCC) and a reference potential (M), further comprising two storage branches each of which is formed of the series connection of a non-volatile storage element (TM1, TM2) of electrically programmable threshold voltage MOS transistor type and of an interrupter element (T5, T6 or T15, T16) of MOS transistor type one terminal of each of the interrupter elements being connected to the supply potential, one of the main terminals and the control terminal of the storage element of the first branch being respectively connected to the node Q and to the node Q* and vice versa in the storage element of the second branch ; characterized in that the two control terminals of the interrupter elements are both connected to a control signal source (CR) ; and in that means are provided for modifying the supply potential (VCC) in relation to the control signal (CR) in the following manner :

— in normal operation of the latch the supply potential (VCC) has a normal value and the control signal (CR) maintains the two interrupter transistors in the blocked states ;

— during a storage input phase, the supply potential is raised to a higher value and the control signal maintains the two interrupter transistors in their blocked states ;

— during a remanent storage phase the supply potential and the control signal are arbitrary ;

— during a reset phase the control signal biases the two interrupter transistors into their conductive states whereupon the supply potential is raised from zero to its normal value.

2. Non-volatile bistable latch according to claim 1, characterized in that it further comprises P-channel MOS transistors (T7, T8, figure 5) respectively inserted between each of the storage elements (TM1, TM2) and the nodes Q and Q*, the potential applied to the gates of these MOS transistors being identical to the value of the signal CR except for the storage input phase.

3. Latch according to claim 1, wherein the interrupter transistors are of P-channel type and the storage elements are of N-channel type, characterized in that additional P-channel transistors (T9, T10, figure 7) are provided in each of the branches of the bistable latch between the additional transistors forming these branches, these additional P-channel transistors being controlled by a control signal CR* which is complementary to the control signal applied to the interrupter elements (T5, T6).

4. Non-volatile bistable latch (figure 6) formed of a conventional bistable latch having MOS transistors (T1 to T4) comprising nodes Q and Q* and connected between a supply line (VCC) and a reference potential (M), further comprising two storage branches each of which is formed by the series connection of a non-volatile storage element (TM1, TM2) of the electrically programmable threshold voltage MOS transistor type and of an interrupter element (T5, T6) of the MOS transistor type, one terminal of each of the interrupter elements being connected to a further supply line (VCC2), one of the main terminals and the control terminal of the storage element of the first branch being respectively connected to the nodes Q and Q*, and vice versa in the storage element of the second branch ; characterized in that the two control terminals of the interrupter elements are both connected to a control signal source (CR) ; and in that means are provided for modifying the supply potential (VCC) in relation to the control signal (CR) in the following manner :

— in normal operation of the latch the supply lines are switched to normal potential values and the control signal maintains the two interrupter transistors in their blocked states ;

— during a storage input phase the supply lines are raised to higher potentials and the control signal maintains the two interrupter transistors in their blocked states ;

— during a remanent storage phase the supply lines and the control signal are connected to arbitrary values ;

— during a reset phase the control signal biases the interrupter transistors into their conductive states whereupon the first supply line (VCC) is left in a floating state while the second is raised from zero to its normal value, and subsequently the first line is connected to its normal potential.

5. Non-volatile bistable latch formed of a conventional bistable latch having MOS transistors and comprising nodes Q and Q*, and connected between a supply potential and a reference potential, further comprising a storage branch formed by the series connection of a non-volatile storage element of electrically programmable threshold voltage MOS transistor type and of an interrupter element of the MOS transistor type, one terminal of the interrupter element being connected to the supply potential, one of the main terminals and the control terminal of the storage element being connected to the node Q and to the node Q*, respectively, characterized in that the control terminal of the interrupter element is connected to a control signal source, and in that means are provided for modifying the supply potential is relation to the control signal in the following manner :

— in normal operation of the latch the supply potential has a normal value and the control signal maintains the interrupter transistor in its blocked state ;

— during a storage input phase the supply potential is raised to a higher value and the control signal maintains the interrupter transistor in its blocked state ;

— during a phase of remanent storage the supply potential and the control signal are arbitrary ;

— during a reset phase the control signal biases the interrupter transistor into its conductive state whereupon the supply potential is raised from zero to its normal value.

**Patentansprüche**

1. Bistabile nichtflüchtige Speicher-Kippschaltung (Figur 2, 5, 7 oder 8), gebildet aus einer herkömmlichen bistabilen Kippschaltung mit MOS-Transistoren (T1 bis T4 oder T11 bis T14), die Knotenpunkte Q und Q* aufweist und zwischen ein Versorgungspotential (VCC) und ein Referenzpotential (M) geschaltet ist, ferner mit zwei Speicherzweigen, wovon jeder gebildet ist durch die Reihenschaltung eines nichtflüchtigen Speicherelementes (TM1, TM2) vom MOS-Transistortyp mit elektrisch programmierbarem Schwellwert und aus einem Unterbrecherelement (T5, T6 oder T15, T16) vom MOS-Transistortyp, wobei ein Anschluß jedes der Unterbrecherelemente mit dem Versorgungspotential verbunden ist, einer der Hauptanschlüsse und der Steueranschluß des Speicherelementes des ersten Zweiges mit dem Knotenpunkt Q bzw. mit dem Knotenpunkt Q* verbunden sind, und umgekehrt für das Speicherelement des zweiten Zweiges ; dadurch gekennzeichnet, daß die beiden Steuerzweige der Unterbrecherelemente gemeinsam mit einer Steuersignalquelle (CR) verbunden sind ; und daß Mittel vorgesehen sind, um das Versorgungspotential (VCC) in Beziehung zu dem Steuersignal (CR) folgendermaßen zu verändern :

— Im normalen Betrieb der Kippschaltung weist das Versorgungspotential (VCC) einen normalen Wert auf, und das Steuersignal (CR) hält die zwei Unterbrechertransistoren im gesperrten Zustand ;

— während einer Einspeicherungsphase wird das Versorgungspotential auf einen größeren Wert angehoben, und das Steuersignal hält die zwei Unterbrechertransistoren im gesperrten Zustand ;

— während einer Phase der remanenten Speicherung sind das Versorgungspotential und das Steuersignal beliebig ;

— während einer Rücksetzphase bringt das Steuersignal die zwei Unterbrechertransistoren in den leitenden Zustand, woraufhin das Versorgungspotential von Null auf seinen normalen Wert gebracht wird.

2. Bistabile nichtflüchtige Speicher-Kippschaltung nach Anspruch 1, dadurch gekennzeichnet, daß sie ferner P-Kanal-MOS-Transistoren (T7, T8, Figur 5) enthält, die jeweils zwischen eines der Speicherelemente (TM1, TM2) und einen Knotenpunkt Q bzw. Q* eingefügt sind, wobei das an die Gates dieser MOS-Transistoren angelegte Potential identisch mit dem Wert des Signals CR ist, außer während der Einspeicherungsphase.

3. Kippschaltung nach Anspruch 1, bei welcher die Unterbrechertransistoren vom P-Kanal-Typ sind und die Speicherelemente vom N-Kanal-Typ sind, dadurch gekennzeichnet, daß zusätzliche P-Kanal-Transistoren (T9, T10, Figur 7) in jedem der Zweige der bistabilen Kippschaltung zwischen den diese Zweige bildenden weiteren Transistoren vorgesehen sind, wobei diese zusätzlichen P-Kanal-Transistoren durch ein Steuersignal CR* gesteuert werden, welches komplementär zu dem Steuersignal ist, das an die Unterbrecherelemente (T5, T6) angelegt wird.

4. Bistabile nichtflüchtige Speicher-Kippschaltung (Figur 6), die aus einer herkömmlichen bistabilen MOS-Transistor-Kippschaltung (T1 bis T4) gebildet ist, die Knotenpunkte Q und Q*

enthält und zwischen eine Versorgungsleitung (VCC) und ein Referenzpotential (M) geschaltet ist, ferner mit zwei Speicherzweigen, wovon jeder gebildet ist durch die Reihenschaltung eines nichtflüchtigen Speicherelementes (TM1, TM2) vom MOS-Transistortyp mit elektrisch programmierbarer Schwellspannung und aus einem Unterbrecherelement (T5, T6) vom MOS-Transistortyp, wobei ein Anschluß jedes der Unterbrecherelemente mit einer weiteren Versorgungsleitung (VCC2) verbunden ist, einer der Hauptanschlüsse sowie der Steueranschluß des Speicherelementes des ersten Zweiges mit dem Knotenpunkt Q bzw. dem Knotenpunkt Q* verbunden ist, und umgekehrt für das Speicherelement des zweiten Zweiges ; dadurch gekennzeichnet, daß die zwei Steueranschlüsse der Unterbrecherelemente gemeinsam mit einer Steuersignalquelle (CR) verbunden sind ; und daß Mittel vorgesehen sind, um das Versorgungspotential (VCC) in Beziehung zu dem Steuersignal (CR) in folgender Weise zu verändern :

— Im Normalbetrieb der Kippschaltung sind die Versorgungsleitungen auf normale Potentialwerte gelegt, und das Steuersignal hält die zwei Unterbrechertransistoren im gesperrten Zustand ;

— während einer Einspeicherungsphase werden die Versorgungsleitungen auf höhere Potentiale gelegt, und das Steuersignal hält die zwei Unterbrechertransistoren im gesperrten Zustand ;

— während einer Phase der remanenten Speicherung werden die Versorgungsleitungen und das Steuersignal auf beliebige Werte gelegt ;

— während einer Rücksetzphase bringt das Steuersignal die Unterbrechertransistoren in den leitenden Zustand, woraufhin die erste Versorgungsleitung (VCC) zunächst im Schwebezustand gehalten wird, während die zweite von Null auf ihren Normalwert gebracht wird, woraufhin die erste Leitung auf ihr normales Potential gelegt wird.

5. Bistabile nichtflüchtige Speicher-Kippschaltung, gebildet aus einer herkömmlichen bistabilen MOS-Transistor-Kippschaltung, welche Knotenpunkte Q und Q* enthält sowie zwischen ein Versorgungspotential und ein Referenzpotential geschaltet ist, ferner mit einem Speicherzweig, der durch die Reihenschaltung eines nichtflüchtigen Speicherelementes vom MOS-Transistortyp mit elektrisch programmierbarer Schwellspannung und eines Unterbrecherelementes vom MOS-Transistortyp gebildet ist, wobei ein Anschluß des Unterbrecherelementes mit dem Versorgungspotential verbunden ist und einer der Hauptanschlüsse sowie der Steueranschluß des Speicherelementes mit dem Knotenpunkt Q bzw. dem Knotenpunkt Q* verbunden sind, dadurch gekennzeichnet, daß der Steueranschluß des Unterbrecherelementes mit einer Steuersignalquelle verbunden ist und daß Mittel vorgesehen sind, um das Versorgungspotential in Beziehung zu dem Steuersignal in folgender Weise zu verändern :

— Im Normalbetrieb der Kippschaltung besitzt das Versorgungspotential einen normalen Wert, und das Steuersignal hält den Unterbrechertransistor im gesperrten Zustand ;

— während einer Einspeicherungsphase wird das Versorgungspotential auf einen größeren Wert angehoben, und das Steuersignal hält den Unterbrechertransistor im gesperrten Zustand ;

— während einer Phase der remanenten Speicherung sind das Versorgungspotential wie das Steuersignal beliebig ;

— während einer Rücksetzphase bringt das Steuersignal den Unterbrechertransistor in den leitenden Zustand, woraufhin das Versorgungspotential von Null auf seinen normalen Wert gebracht wird.

Vcc

CR

3

2

1

Q*

Q

Q

Q*

M

# Fig.1

Vcc

T5

CR

P

TM1

N

T2

P

T4

P

Q*

Q

Q

Q*

T1

N

T3

N

M

T6

P

CR

TM2

N

# Fig.2

Fig. 3

Fig. 4

2

Fig.5

Fig.6

VCC

T5 P    P T6    CR

T2    T4
P          P

P          P
CR*
T9          T10

Q*          Q

T1    T3

**Fig.7**

VCC

T15          T16
CR    N          N    CR

1

TM1          TM2
N    T12    T14    N
N          N
Q*          Q

Q          Q*

N          N
T11    T13

**Fig.8**